# EUROPEAN PATENT APPLICATION

(11) **EP 4 336 977 A1**
(43) Date of publication of application: **13.03.2024**
(21) Application number: 22806278.2
(22) Date of filing: 15.03.2022
(51) Int. Cl.: H05K 3/46

(54) **METHOD FOR PREPARING MULTI-LAYER CIRCUIT BOARD**

(30) Priority: 11.05.2021 CN 202110510653
(71) Applicant: ZTE Corporation, Shenzhen, Guangdong 518057 (CN)
(72) Inventor: XIE, Jian, Shenzhen, Guangdong 518057 (CN); WEI, Zhongmin, Shenzhen, Guangdong 518057 (CN); ZHANG, Qiang, Shenzhen, Guangdong 518057 (CN)
(74) Representative: Canzler & Bergmeier Patentanwälte Partnerschaft mbB
(86) International application number: PCT/CN2022/080935
(87) International publication number: WO 2022/237303

(57) **Abstract**

The present disclosure provides a method for preparing a multi-layer circuit board. The method comprises: forming a preset through hole at the position which corresponds to a locally conductive through hole and is on each preset core board of a multi-layer circuit board, and forming a preset conductive structure in the preset through hole, wherein the locally conductive through hole is a through hole in the multi-layer circuit board that has a conductive structure only at the position corresponding to part of the core board, the preset core board is a core board corresponding to the conductive structure in at least one locally conductive through hole, and the aperture of the preset through hole is greater than that of the locally conductive through hole; laminating all the core boards of the multi-layer circuit board, and performing press-fitting once to obtain a press-fit structure; forming the locally conductive through hole in the press-fit structure, so that the preset conductive structure forms a preset conductive layer; and electroplating the press-fit structure, so that the conductive structure is formed only at the the preset conductive layer in the locally conductive through hole.

## Description

### CROSS-REFERENCE TO RELATED APPLICATIONS

The present application claims the priority of Chinese Patent Application 202110510653.4, filed on May 11, 2021, the contents of which are incorporated herein in their entirety by reference.

### TECHNICAL FIELD

The present disclosure relates to the technical field of multi-layer circuit board, in particular to a method for preparing a multi-layer circuit board.

### BACKGROUND

There may be a local conductive through hole, in a multi-layer circuit board (PCB), configured to conduct only part of core boards of the multi-layer circuit board, so that a conductive structure may be only disposed at a position of the local conductive through hole corresponding to the core boards to be electrically conducted with each other, or the local conductive through hole may be electroplated with copper at any selected position thereof, so as to avoid unnecessary conduction and reduce a loss.

With the development of technology, a density and a signal rate of the multi-layer circuit board are continuously improved. For example, a serial signal rate of a carrier network in 5G communication (the fifth generation mobile communication) technology can reach 112Gbps or even 224Gbps, and thus higher expectations are correspondingly put forward for the performance of the multi-layer circuit board.

### SUMMARY

An embodiment of the disclosure provides a method for preparing a multi-layer circuit board, including: forming a preset through hole at a position of each preset core board, corresponding to a local conductive through hole, of the multi-layer circuit board, and forming a preset conductive structure in the preset through hole, the local conductive through hole being a through hole having a conductive structure therein only at a position of the multi-layer circuit board corresponding to part of core boards, the preset core board being the core board corresponding to the conductive structure in at least one local conductive through hole, and an aperture of the preset through hole being greater than an aperture of the local conductive through hole; stacking and pressing all the core boards of the multi-layer circuit board together to obtain a compression structure; forming the local conductive through hole in the compression structure, so that the preset conductive structure is formed into a preset conductive layer; and electroplating the compression structure, so that the conductive structure is formed only at a position, corresponding to the preset conductive layer, in the local conductive through hole.

### DESCRIPTION OF DRAWINGS

In the drawings of the embodiment of the present disclosure:
Fig. 1 is a schematic cross-sectional view of a compression structure, before being subjected to back drilling, in a multi-layer circuit board according to the related art;
FIG. 2 is a schematic cross-sectional view of a compression structure, after being subjected to back drilling, in a multi-layer circuit board according to the related art;
FIG. 3 is a flowchart of a method for preparing a multi-layer circuit board according to the present disclosure;
FIG. 4 is a flowchart of a method for preparing a multi-layer circuit board according to the present disclosure;
Fig. 5 is a schematic cross-sectional view of a local structure of each core board formed with a preset through hole in a method for preparing a multi-layer circuit board according to the present disclosure;
Fig. 6 is a schematic cross-sectional view of a local structure of each core board formed therein with a preset conductive structure in a method for preparing a multi-layer circuit board according to the present disclosure;
Fig. 7 is a schematic cross-sectional view of a local structure of a compression structure in a method for preparing a multi-layer circuit board according to the present disclosure;
Fig. 8 is a schematic cross-sectional view of a local structure of a compression structure formed therein with a local conductive through hole in a method for preparing a multi-layer circuit board according to the present disclosure;
Fig. 9 is a schematic cross-sectional view of a local structure of a compression structure formed therein with a conductive structure in a method for preparing a multi-layer circuit board according to the present disclosure;
Fig. 10 is a schematic cross-sectional view of a local structure of a multi-layer circuit board obtained by a method for preparing a multi-layer circuit board according to the present disclosure;
Fig. 11 is a schematic cross-sectional view of a local structure of each core board formed with a preset through hole in a method for preparing a multi-layer circuit board according to the present disclosure;
Fig. 12 is a schematic cross-sectional view of a local structure of each core board formed therein with a preset conductive structure in a method for preparing a multi-layer circuit board according to the present disclosure;
Fig. 13 is a schematic cross-sectional view of a local structure of a compression structure in a method for preparing a multi-layer circuit board according to the present disclosure;
Fig. 14 is a schematic cross-sectional view of a local structure of a compression structure formed with a local conductive through hole in a method for preparing a multi-layer circuit board according to the present disclosure;
Fig. 15 is a schematic cross-sectional view of a local structure of a compression structure formed therein with a conductive structure in a method for preparing a multi-layer circuit board according to the present disclosure;
Fig. 16 is a schematic cross-sectional view of a local structure of a multi-layer circuit board obtained by a method for preparing a multi-layer circuit board according to the present disclosure; and
FIG. 17 is a graph illustrating a loss test of a multi-layer circuit board provided by a method for preparing a multi-layer circuit board according to the present disclosure and a multi-layer circuit board according to the related art.

Reference signs include: 1. core board; 11. preset core board; 111. preset through hole; 2. adhesive layer; 3. compression structure; 31. local conductive through hole; 41. preset conductive structure; 411. protruding portion; 42. preset conductive layer; 5. conductive structure.

### DESCRIPTION OF EMBODIMENTS

In order to enable a person skilled in the art to better understand the present disclosure, the method for preparing the multi-layer circuit board provided by the embodiment of present disclosure will be described fully hereinafter with reference to the drawings.

Exemplary implementations will be described fully hereinafter with reference to the drawings, but the implementations may be embodied in different forms and should not be construed as limited to those set forth herein. These implementations are provided so that the present disclosure will be thorough and complete, and will fully convey the scope of the present disclosure to a person skilled in the art.

The accompanying drawings of the embodiment of the present disclosure are used to provide a further understanding of the disclosed embodiment and constitute a part of the specification, together with the embodiment of the present disclosure to explain the present disclosure but not to limit the present disclosure. The above and other features and advantages will become more apparent to a person skilled in the art by describing in detail the exemplary embodiment with reference to the accompanying drawings.

The embodiment of the present disclosure may be described with reference to plan and/or cross-sectional views by way of idealized schematic illustrations of the present disclosure. Accordingly, the example illustrations may be modified in accordance with manufacturing techniques and/or tolerances.

Implementations of the embodiment and features in the implementations may be combined with each other without any conflict.

The terms used herein are merely used to describe the specific embodiment, but are not intended to limit the present disclosure. As used herein, the term "and/or" includes any and all combinations of at least one associated listed item. As used herein, terms "a", "an" and "the" which indicate a singular form are intended to include a plural form, unless expressly stated in the context. It should be further understood that the term(s) "comprise/include" and/or "be made of" used herein indicate(s) the presence of the described features, integers, operations, elements and/or components, but do/does not exclude the presence or addition one or more other features, integers, operations, elements, components and/or combinations thereof.

Unless otherwise defined, all terms (including technical and scientific terms) used herein have the same meaning as commonly understood by those of ordinary skill in the art. It should be further understood that terms, such as those defined in commonly used dictionaries, should be interpreted as having a meaning that is consistent with a meaning in the context of the related technology and the background of the present disclosure, and should not be interpreted in an idealized or overly formal sense unless expressly so defined herein.

The embodiment of present disclosure is not limited to the implementations shown in the accompanying drawings, but include modifications of configurations formed based on manufacturing processes. Thus, the regions illustrated in the accompanying drawings have schematic properties, and the shapes of the regions shown in the drawings illustrate specific shapes of regions of elements, but are not intended to limit the present disclosure.

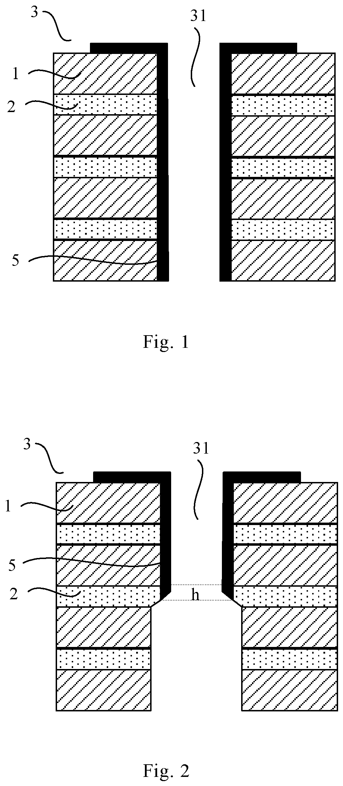

In the related art, the local conductive through hole 31 may be formed in the multi-layer circuit board by a process of back drilling, as shown in Fig. 1. Specifically, as shown in Fig. 1, first, all core boards 1 (an adhesive layer 2, such as prepreg or half cured adhesive sheet, may also be incorporated) are pressed together to obtain a compression structure 3, then a local conductive through hole 31 formed therein with a conductive structure 5 at all positions thereof is formed in the compression structure 3, thereafter, expanded drilling (back drilling) is performed on the local conductive through hole 31 from a side thereof not to be conductive, and the conductive structure 5 corresponding to the core board 1 not to be conducted is "drilled away", so that the local conductive through hole 31 formed therein with the conductive structure 5 only at part of the positions thereof as shown in Fig. 2 is formed.

However, on one hand, due to the influence of a drilling machine, a drilling cutter, any process, etc., the back drilling cannot "exactly" reach the position at which the core board 1 to be conducted is located, but a margin (h between two dotted lines in Fig. 2) with a length usually ranging from 8 mils to 12 mils is "remained", and the conductive structure 5 corresponding to the margin is called a "stub" left by the back drilling, the stub will lead to an increased loss and affect a design of a link (especially for a high-density multi-layer circuit board).

On the other hand, by performing the back drilling, the conductive structure 5 can be removed only from two sides of the multi-layer circuit board, so that there is only "one" conductive structure 5 remained in each local conductive through hole 31, and the local conductive through hole 31 can only be "one hole with one channel". That is, in the multi-layer circuit board, it is impossible to form a plurality of independent conductive structures 5 (a network structure with broken layers) in one local conductive through hole 31 by the back drilling, that is, "one hole with multiple channels" cannot be achieved.

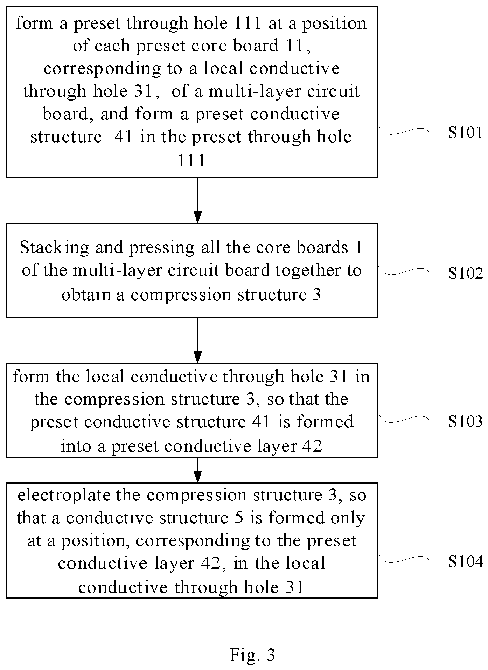

Referring to Fig. 3 to Fig.17, an embodiment of the present disclosure provides a method for preparing a multi-layer circuit board.

The embodiment of the present disclosure are used for preparing a multi-layer circuit board (PCB), and in particular, a multi-layer circuit board formed by a single process of pressing, that is, all core boards 1 of the multi-layer circuit board are press together in the single process of pressing.

The multi-layer circuit board prepared by the embodiment of the present disclosure may be a multi-layer circuit board with a relatively high density and a relatively high serial signal rate (e.g., 112Gbps or even 224Gbps), which may be used in any field, such as in a carrier network of the communication technology (e.g., 5G communication technology).

Referring to Fig. 3, the method for preparing the multi-layer circuit board in the embodiment of the present disclosure includes following operations S101 to S104.

At S101, forming a preset through hole 111 at a position of each preset core board 11, of the multi-layer circuit board, corresponding to a local conductive through hole 31, and forming a preset conductive structure 41 in the preset through hole 111.

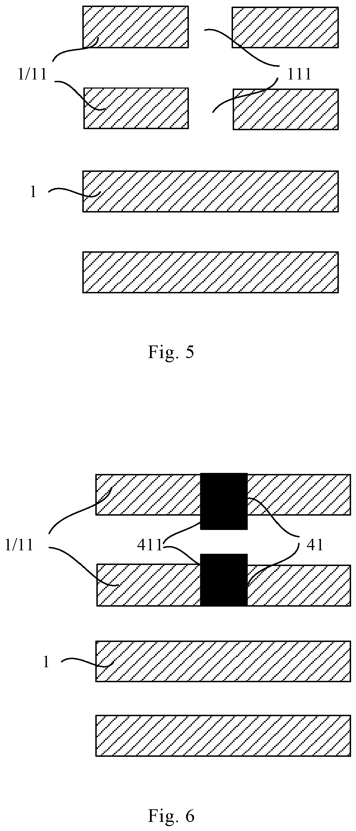

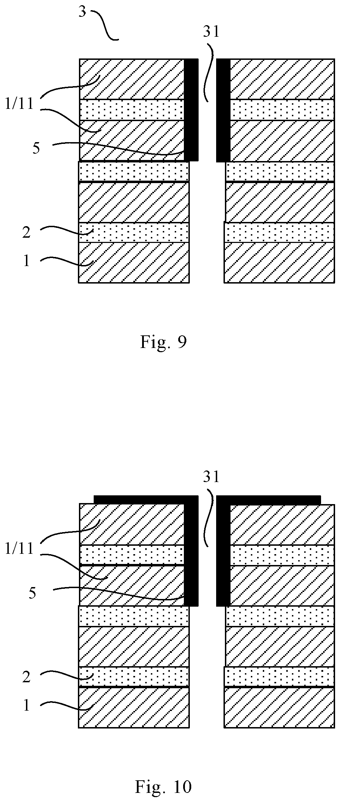

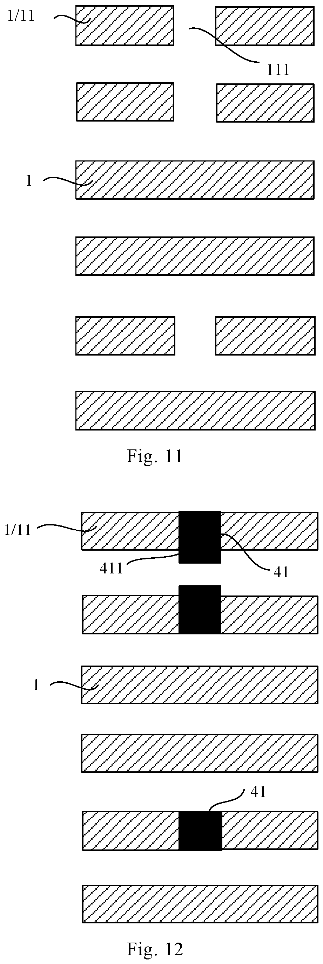

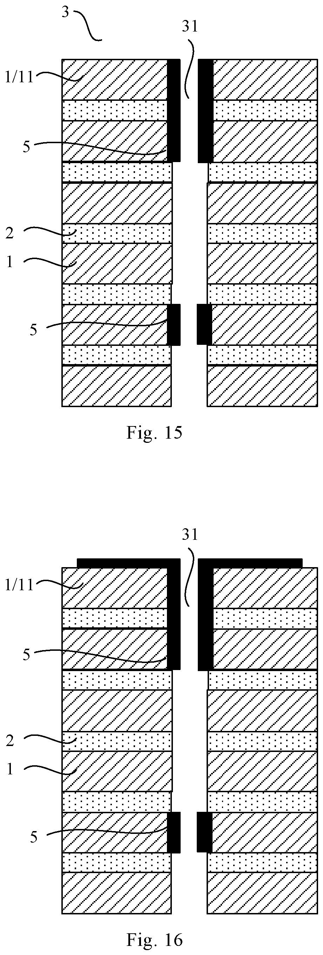

Referring to Fig. 10 and Fig. 16, the local conductive through hole 31 is a through hole, in the multi-layer circuit board, formed therein with a conductive structure 5 only at a position thereof corresponding to part of core boards 1, or a through hole to be electroplated with copper at any selected position thereof, the preset core board 11 is the core board 1 corresponding to the conductive structure 5 in at least one local conductive through hole 31, and referring to Fig. 5 and Fig. 11, an aperture of the preset through hole 111 is greater than an aperture of the local conductive through hole 31.

The multi-layer circuit board of the embodiment of the present disclosure is obtained by pressing a plurality of core boards 1 together, and the multi-layer circuit board has at least one local conductive through hole 31 therein. In the local conductive through hole 31, only part of positions are provided with the conductive structure 5, and the conductive structures 5 only enable part of the core boards 1 to be electrically conducted with each other, and these core boards 1 are called "preset core boards 11". Thus, among the plurality of core boards 1 forming the multi-layer circuit board, at least part of the core boards 1 each may be the preset core board 11 mentioned above.

Referring to Fig. 5 and Fig. 11, for each individual preset core board 11, before performing the process of pressing, a hole is drilled in the preset core board 11 to form the preset through hole 111 at the position of the preset core board 11 corresponding to the local conductive through hole 31, so that the aperture of the preset through hole 111 is greater than the aperture of the local conductive through hole 31, for example, by at least 2 mils.

Then, referring to Fig. 6 and Fig. 12, for each individual preset core board 11, the preset conductive structure 41 is formed in the preset through hole 111.

It should be understood that each preset through hole 111 mentioned above corresponds to the local conductive through hole 31 specifically determined, and only the structure of one preset through hole 111 is described in the embodiment of the present disclosure.

For example, if there are a plurality of local conductive through holes 31 in any multi-layer circuit board, and different local conductive through holes 31 are configured to enable different core boards 1 to be electrically conducted with each other, for any core board 1 (i.e., preset core board 11), it may be possible that the core board 1 is to be conducted only at one local conductive through hole 31, and thus the preset through hole 111 and subsequent structures are only to be formed at the position of the core board 1 corresponding to the local conductive through hole 31, but not at the position of the core board 1 corresponding to any other local conductive through hole 31, and other structures of the core boards 1 are similar to each other.

Certainly, for each core board 1, as long as any preset through hole 111 is to be formed therein, the core board 1 can be called the preset core board 11, and the preset through hole 111 and other related structures are to be formed at a corresponding position of the core board 1 (i.e., the preset core board 11).

At S102, stacking and pressing all core boards 1 of the multi-layer circuit board together to obtain a compression structure 3.

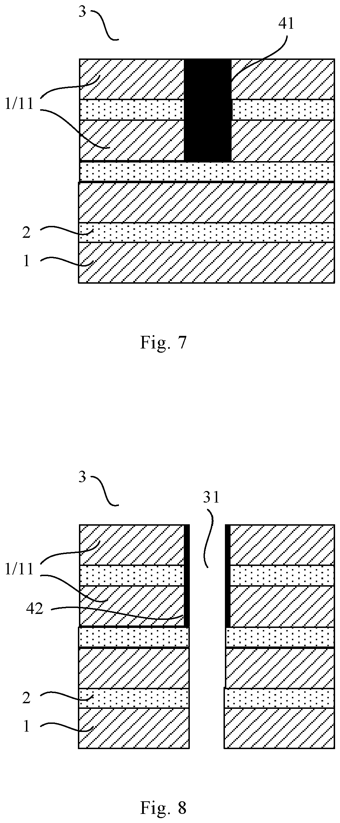

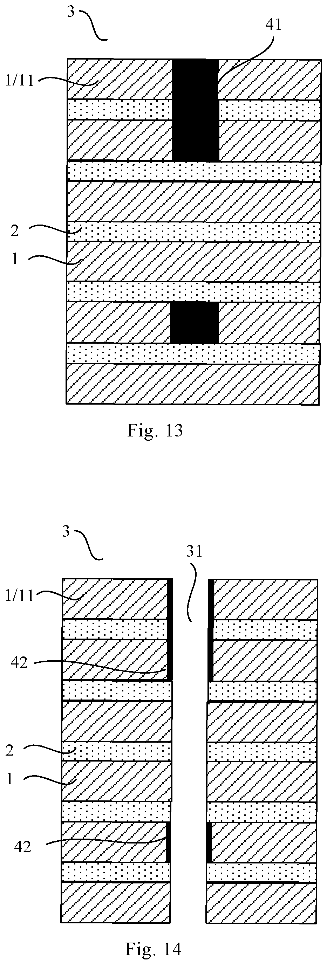

Referring to Fig. 7 and Fig. 13, all the core boards 1 are stacked and pressed together by a single process of processing to obtain the compression structure 3.

Obviously, among all the core boards 1, at least part of the core boards 1 are the preset core boards 11 formed therein with preset conductive structures 41 and preset through holes 111.

It should be understood that, in the compression structure 3, different preset conductive structures 41 may be still independent structures and are not well electrically conducted with each other, even if they are in contact with each other.

At S103, forming the local conductive through hole 31 in the compression structure 3, so that the preset conductive structure 41 is formed into a preset conductive layer 42.

Referring to Fig. 8 and Fig. 14, the local conductive through hole 31 is formed in the compression structure 3, and since the aperture of the preset through hole 111 is greater than the aperture of the local conductive through hole 31, at least an outer portion of the preset conductive structure 41 is located "outside" the local conductive through hole 31, so that after the local conductive through hole 31 is formed, at least the outer portion of the preset conductive structure 41 is remained to form a relatively thin layer (i.e., the preset conductive layer 42) on an inner wall of the preset through hole 111.

Obviously, in a thickness direction of the compression structure 3 (i.e., in a stacking direction of the core boards 1, in which the core boards 1 are stacked), the preset conductive layer 42 is only located at the position corresponding to the preset conductive structure 41, that is, only at the position of the preset core board 11 to be conducted.

At S104, electroplating the compression structure 3, so that a conductive structure 5 is formed only at a position, corresponding to the preset conductive layer 42, in the local conductive through hole 31.

Referring to Fig. 9 and Fig. 15, the compression structure 3 is directly electroplated without any chemical plating, so that the preset conductive layer 42 in the local conductive through hole 31 is thickened by electroplating to form the conductive structure 5 in the local conductive through hole 31. Meanwhile, there was no conductive layer at other positions, except the position at which the preset conductive layer 42 is located, in the local conductive through hole 31, therefore, after the electroplating, no conductive material will be deposited at the positions, except the position at which the preset conductive layer 42 is located, in the local conductive through hole 31.

In this way, the conductive structure 5 is formed in the local conductive through hole 31 only at the position corresponding to the preset conductive layer 42 (also corresponding to the preset conductive structure 41), so that the conductive structure 5 is located only at the position of the core board 1 (i.e., the preset core board 11) to be conducted, that is, the local conductive through hole 31 being electroplated at any selected position thereof is achieved.

Since the conductive structure 5 is formed by electroplating, a plurality of preset conductive layers 42 that are originally in contact with each other but are not electrically connected well are effectively connected into an entire structure, and thus are well electrically conducted with each other.

It should be understood that a corresponding conductive layer (e.g., leads, joint pads) may be formed on a surface of each core board 1 to be electrically conducted with the conductive structure 5, and is connected to the conductive structure 5, which will not be described in detail herein.

It should be understood that, after the conductive structure 5 is formed in the local conductive through hole 31, outer pattern transferring, outer surface processing, profile milling, shipment detecting, etc. may be further performed, and then, referring to Fig. 10 and Fig. 16, the multi-layer circuit board having other structures (e.g., joint pads or the like connected to the conductive structure 5 in the local conductive through hole 31) is obtained, which will not be described in detail herein.

In the embodiment of the present disclosure, the preset conductive structure 41 is first formed in the preset core board 11 to be electrically conducted with the local conductive through hole 31, and then all the core boards 1 (including the preset core board 11) are pressed together and drilled, so that the preset conductive structure 41 is formed into the preset conductive layer 42, and the preset conductive layer 42 is directly electroplated without any chemical plating to be thickened, so that the conductive structure 5 in the local conductive through hole 31 is formed.

Therefore, the preset conductive structure 41 is formed in the each individual core board 1 (i.e., the preset core board 11), and is only located at the position corresponding to the core board 1 (i.e., the preset core board 11) to be conducted, so that the preset conductive layer 42 and the conductive structure 5 in the local conductive through hole 31, which are formed subsequently from the preset conductive structure 41, are also located only at the position corresponding to the core board 1 (i.e., the preset core board 11) to be conducted, thereby completely avoiding the stub (i.e., zero stub is achieved), reducing the loss by about 25% to about 30%, improving the signal quality, and facilitating the design of the link(especially for the high-density multi-layer circuit board).

Moreover, the preset conductive structure 41 is formed in each individual core board 1 (i.e., the preset core board 11), and thus a plurality of independent preset conductive layers 42 may be formed in each local conductive through hole 31 of the compression structure 3, and further referring to Fig. 15, a plurality of independent conductive structures 5 may be correspondingly formed in each local conductive through hole 31 subsequently, so as to form a plurality of "channels" in the local conductive through hole 31, that is, "one hole with multiple channels" is realized in a case where the multi-layer circuit board is formed by a single process of pressing (i.e., not multiple pressing processes, which facilitates to achieve a high-density design, can greatly simplify the preparation process, and improve the production efficiency (the production cycle can be shortened by about 1/4).

In addition, all processes, materials and the like in the embodiment of the present disclosure may refer to the production of the conventional multi-layer circuit board, and no special plating resistant films, plating resistant printing inks or the like is desired to be provided, so that the method of the present disclosure can be well combined with the conventional processes, and thus costs low and is easy to be realized.

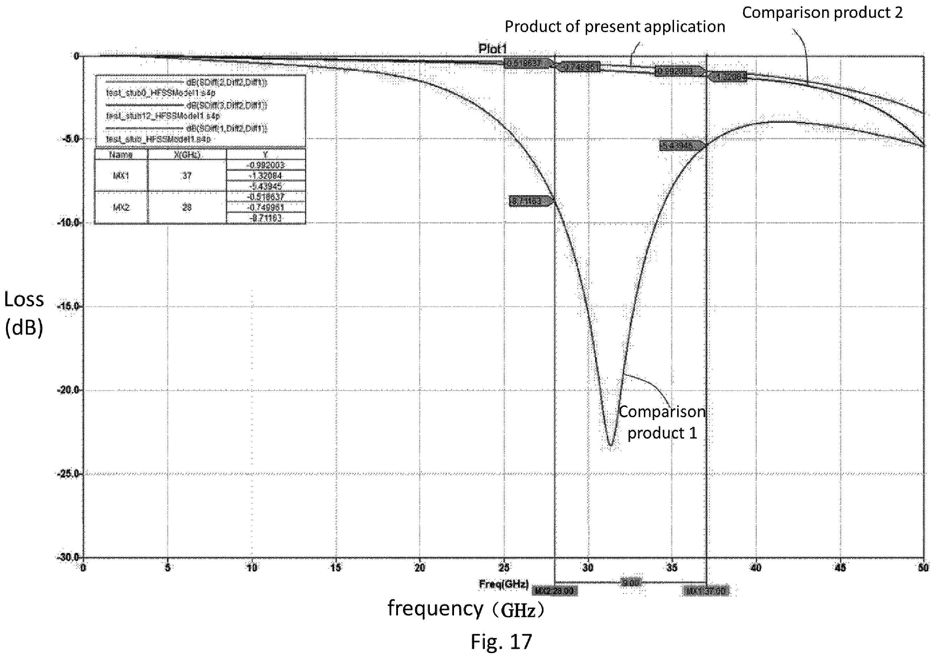

For the multi-layer circuit board (i.e., the product, in the present application, without any stub) prepared by the method of the embodiment of the present disclosure, the multi-layer circuit board with the through hole fully filled by the conductive structure 5 (comparison product 1, with the through hole fully filled by the stub), and the multi-layer circuit board prepared by the process of back drilling (comparison product 2, having a stub with a length of 12 mils), losses of these three different multi-layer circuit boards are tested at different frequencies, and the results are shown in Fig. 17.

Therefore, the multi-layer circuit board prepared by the method of the embodiment of the present disclosure, compared with the multi-layer circuit board, having the stub, prepared by the process of back drilling, or the multi-layer circuit board with the through hole fully filled by the conductive structure 5, can greatly reduce the loss due to eliminating the stub.

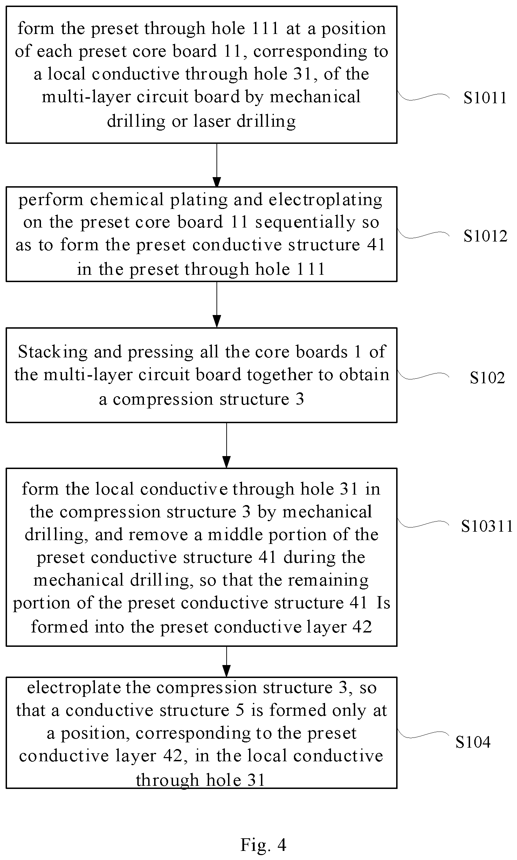

In some implementations, referring to Fig. 4, the forming a preset through hole 111 at a position of each preset core board 11, of the multi-layer circuit board, corresponding to a local conductive through hole 31 (S 101) includes following operation S1011.

At S1011, forming the preset through hole 111 at the position of each preset core board 11, of the multi-layer circuit board, corresponding to the local conductive through hole 31 by mechanical drilling or laser drilling.

In some implementations, referring to Fig. 4, the forming a preset conductive structure 41 in the preset through hole 111 (S101) includes following operation S1012.

At S1012, sequentially performing chemical plating and electroplating on the preset core board 11 so as to form the preset conductive structure 41 in the preset through hole 111.

For each preset core board 11, the preset through hole 111 may be formed therein by means of mechanical drilling or laser drilling, and the preset conductive structure 41 is formed in the preset through hole 111 by means of electroplating subsequent to chemical plating.

In some implementations, there is an adhesive layer 2 between any two adjacent core boards 1 of the multi-layer circuit board, and for two preset conductive structures 41 located at corresponding positions of any two adjacent preset core boards 11, at least one preset conductive structure 41 has a protruding portion 411 which exceeds the preset through hole 111 where the preset conductive structure 41 is located and extends towards the other preset conductive structure 41, and in a stacking direction of the preset core boards 11 in which the preset core boards are stacked, a length of the protruding portion 411 is greater than or equal to a thickness of the adhesive layer 2.

In some implementations, for two preset conductive structures 41 located at corresponding positions of any two adjacent preset core boards 11, each preset conductive structure 41 has a protruding portion 411 which exceeds the preset through hole 111 where the preset conductive structure 41 is located and extends towards the other preset conductive structure 41, and in the stacking direction of the preset core boards 11, a total length of protruding portions 411 of the two preset conductive structures 41 is greater than or equal to the thickness of the adhesive layer 2.

Referring to Fig. 7 and Fig. 13, in order to connect all the core boards 1 of the multi-layer circuit board together, an adhesive layer 2 (e.g., prepreg, or half cured adhesive sheet) may be provided between the core boards 1 for adhering the core boards 1 together.

Obviously, in the embodiment of the present disclosure, the preset conductive structure is not directly formed in the adhesive layer 2. Therefore, in order to form the preset conductive layer 42 and the conductive structure 5 in the local conductive through hole 31 of the adhesive layer 2, referring to Fig. 6 and Fig. 12, the preset conductive structure 41 of the preset core board 11 adjacent to the adhesive layer 2 has the "protruding portion 411" exceeding towards the adhesive layer 2, so that, referring to Fig. 7 and Fig. 13, after pressing the core boards 1 together, the protruding portion 411 is "inserted" into the adhesive layer 2, which is equivalent to forming the preset conductive structure 41 in the adhesive layer 2.

Further, the preset conductive structure 41 of each of the preset core boards 11 on both sides of the adhesive layer 2 may have the protruding portion 411, so that two protruding portions 411 "insert" into the adhesive layer 2 from both sides of the adhesive layer 2 to form the preset conductive structure 41 being consecutive in the adhesive layer 2.

In the pressing direction of the core boards 1 in which the core boards 1 are pressed together, a total length of the protruding portion(s) 411 "inserted" into the adhesive layer 2 may exceed the thickness of the adhesive layer 2, or equal to the thickness of the adhesive layer 2, so that the protruding portions 411 of the preset conductive structures 41 of the preset core boards 11 on both sides of the adhesive layer 2 can contact with each other, or the protruding portion 411 of the preset conductive structure 41 of the preset core board 11 on one side of the adhesive layer 2 contacts the preset conductive structure 41 of the preset core board 11 at the other side of the adhesive layer 2, so as to form the preset conductive structure 41 being consecutive in the adhesive layer 2. For example, in a case where the preset conductive structure 41 of each of the preset core boards 11 on both sides of the adhesive layer 2 has the protruding portion 411, if the thickness of the adhesive layer 2 is E in the pressing direction of the core boards 1, a length D of the protruding portion 411 of the preset conductive structure 41 may be equal to E/2.

The thickness of the adhesive layer 2 refers to the thickness of the adhesive layer 2 subjected to the process of pressing.

There are various ways to form the protruding portion 411 mentioned above, for example, the preset through hole 111 may be first plated to be filled and leveled up and then to be locally thickened to form the protruding portion 411, which will not be described in detail herein.

It should be understood that, even if the protruding portions 411 of the preset conductive structures 41 of the preset core boards 11 on both sides of the adhesive layer 2, are in contact with each other, they are still two structures and cannot guarantee to be well electrically conducted with each other. However, through the subsequent process of thickening by electroplating, the conductive structure 5 formed in the adhesive layer 2 will be an integral structure and can achieve a good conduction.

It should be understood that if the conductive structure 5 (e.g., the conductive structure 5 at the lower position in Fig. 15) in the local conductive through hole 31 is only used to conduct two sides of any preset core board 11 with each other, the conductive structure 5 is not desired to enter the adhesive layer 2, and thus the preset conductive structure 41 (e.g., the preset conductive structure 41 at the lower position in Fig. 12) corresponding to the conductive structure 5 is not desired to have the protruding portion mentioned above.

In some implementations, the preset conductive structure 41 is a solid conductive pillar.

Referring to Fig. 6 and Fig. 12, the preset conductive structure 41 formed in each preset core board 11 may be "solid", i.e., may be a solid conductive pillar, for example, particularly may be a solid conductive pillar protruding from the preset core board 11 (a portion of the solid conductive pillar protruding out of the preset core board 11 is the protruding portion 411 mentioned above).

In some implementations, the forming the local conductive through hole 31 in the compression structure 3, so that the preset conductive structure 41 is formed into a preset conductive layer 42 (S103) includes following operation S1031.

At S1031, forming the local conductive through hole 31 in the compression structure 3, and removing a middle portion of the preset conductive structure 41 during forming the local conductive through hole 31, so that the remaining portion of the preset conductive structure 41 is formed into the preset conductive layer 42.

At the position of the compression structure 3 corresponding to the local conductive through hole 31, the preset conductive structure 41 is at the position corresponding to the preset core plate 11, and the core plate 1 itself is at the position corresponding to any other core plate 1. Therefore, during forming the local conductive through hole 31, for the preset conductive structure 41 (e.g., the solid conductive pillar mentioned above), the middle portion of the preset conductive structure 41 is removed, so that the remaining "thin layer" of the preset conductive structure 41 at the periphery serves as the preset conductive layer 42, and for the other core board 1, a hole is drilled in the core board 1.

In some implementations, referring to Fig. 4, the forming the local conductive through hole 31 in the compression structure 3, so that the preset conductive structure 41 is formed into a preset conductive layer 42 (S103) includes following operation S10311.

At S10311, forming the local conductive through hole 31 in the compression structure 3 by mechanical drilling, and removing the middle portion of the preset conductive structure 41 during the mechanical drilling, so that the remaining portion of the preset conductive structure 41 is formed into the preset conductive layer 42.

Moreover, the local conductive through hole 31 may be formed by mechanical drilling, because the process of forming the local conductive through hole 31 is desired to remove a large amount of conductive material (e.g., copper) from the preset conductive structure 41, and the mechanical drilling can better achieve this goal compared to other methods (e.g., laser drilling).

Certainly, the local conductive through hole 31 may be formed in other ways, for example, if the preset conductive structure 41 is a relatively thin layer located in the preset through hole 111, it may not be affected during the process of forming the local conductive through hole 31, and may be remained directly as the preset conductive layer 42.

In some implementations, the conductive structure 5 in the local conductive through hole 31 is a hollow conductive pillar.

Referring to Fig. 9 and Fig. 15, the conductive structure 5 in the local conductive through hole 31 may be formed through the process of thickening by electroplating, since the electroplating solution can flow to any position to form the conductive structure 5, it is feasible that the local conductive through hole 31 is not fully filled by the conductive material electroplated, so that a hollow conductive pillar is formed.

In some implementations, both the preset conductive structure 41 and the conductive structure 5 is formed of a material of copper.

The conductive material of the preset conductive structure 41 and the conductive structure 5 may be copper (Cu), so that the chemical plating and the electroplating accordingly correspond to chemically plating copper and electroplating copper respectively.

Certainly, it is feasible to use other conductive materials for forming the preset conductive structure 41 and the conductive structure 5.

Referring to Fig. 5 to Fig. 10, the method for preparing the multi-layer circuit board according to the embodiment of the present disclosure may specifically include following operations A101 to A111.

At A101, according to design records of the multi-layer circuit board (PCB), determining a position of a local conductive signal hole (i.e., a local conductive through hole, for example, a high-speed signal hole) to be formed by back drilling.

At A102, disintegrating the multi-layer circuit board layer by layer according to the design records, and determining layer structures which are stacked, the layer structures including a prepreg (i.e., adhesive layer), a core board (including a preset core board) and the like.

At A103, determining parameters for drilling and opening a window in each core board relating to the signal hole.

For example, if an aperture of the signal hole is A, an aperture of a hole (i.e., preset through hole) to be drilled in the preset core board is B, and a diameter of a window to be opened in the prepreg is C, it may be set that C iA B+6mils and B ≥ A+2mils.

At A104, performing processes of coating, exposing, developing and the like, on each core board (the core board in any inner layer) to complete pattern transferring of the core board.

At A105, performing mechanical drilling or laser drilling on the preset core board pre-selected, to form a preset through hole.

At A106, filling and leveling up the preset through hole of the preset core board by plating copper, and then locally thickening the copper by plating to obtain a preset conductive structure.

For example, if a thickness of the copper (i.e., protruding portion out of the preset through hole) formed by the thickening is D, and a thickness of the prepreg (i.e., the adhesive layer) subjected to pressing is E, then D=E÷E2.

At A107, opening a window in the prepreg, and exposing a position for forming copper joint pads (i.e., connectors).

At A108, stacking and pressing the prepreg and core boards (including the preset core board) together, to form an entire compression structure.

At A109, performing mechanical drilling on the compression structure to obtain the signal hole mentioned above, with a diameter of a cutter for the drilling being equal to the aperture of the hole B to be drilled, so that the signal hole with the preset conductive layer therein is obtained.

At A110, directly electroplating copper without chemically plating copper, thickening the preset conductive layer to form a conductive structure in the signal hole, and obtain the signal hole plated with copper at a selected position in the signal hole.

If there is another through hole, in the multi-layer circuit board, desired to be completely plated with copper, the another through hole is to be drilled before drilling of the signal hole mentioned above (before A109), and chemical plating is to be performed in the another through hole, and then A109 and A110 are to be performed, that is, for the signal hole mentioned above, the electroplating in A110 is to thicken the preset conductive layer in the signal hole, and for the another through hole, the electroplating in A110 is to form the conductive structure directly in the through hole.

At A111, performing subsequent processes of outer pattern transferring, outer surface processing, profile milling, shipment detecting and the like to obtain the multi-layer circuit board.

Referring to Fig. 11 to Fig. 16, the method for preparing the multi-layer circuit board according to the embodiment of the present disclosure may specifically include following operations A201 to A211.

At A201, according to design records of the multi-layer circuit board (PCB), determining a position of a signal hole (i.e., local conductive through hole) in a mode of "one-hole with multiple channels".

The signal hole in the mode of "one-hole with multiple channels" has a plurality of independent conductive structures (or a network structure with broken layers), which form a plurality of independent signal channels, so that the density of the multi-layer circuit board is higher.

At A202, disintegrating the multi-layer circuit board layer by layer according to the design records, and determining layer structures which are stacked, the layer structures including a prepreg (i.e., adhesive layer), a core board (including a preset core board) and the like.

At A203, determining parameters for drilling and opening a window in each core board relating to the signal hole.

For example, if an aperture of the signal hole is A, an aperture of a hole (i.e., preset through hole) to be drilled in the preset core board is B, and a diameter of a window to be opened in the prepreg is C, it may be set that C iA B+6mils and B ≥ A +2mils.

At A204, performing processes of coating, exposing, developing and the like on each core board (the core board in any inner layer) to complete pattern transferring of each core board.

At A205, performing mechanical drilling or laser drilling on each core plate (i.e., each preset core board) corresponding to the network structure with broken layers, to form a preset through hole.

At A206, filling and leveling up the preset through hole of the preset core board by plating copper, and then locally thickening the copper by plating, so as to obtain a preset conductive structure.

For example, if a thickness of the copper (i.e., protruding portion out of the preset through hole)) formed by the thickening is D, and a thickness of the prepreg (i.e., the adhesive layer) subjected to pressing is E, then D=E÷2.

At A207, opening a window in the prepreg, and exposing a position for forming copper joint pads (i.e., connectors).

At A208, stacking and pressing the prepreg and core boards (including the preset core board) together, to form an entire compression structure.

At A209, performing mechanical drilling on the compression structure to obtain the signal hole mentioned above, with a diameter of a cutter for the drilling being equal to the aperture of the hole B to be drilled, so that the signal hole with the preset conductive layer therein is obtained.

At A210, directly electroplating copper without chemically plating copper, thickening the preset conductive layer to form a conductive structure in the signal hole, and obtain the signal hole plated with copper at positions of the signal hole corresponding to the network structure with broken layers.

If there is another through hole, in the multi-layer circuit board, to be completely plated with copper, the another through hole is to be drilled before drilling the signal hole (before A209), and chemical plating is to be performed in the another through hole, and then A209 and A210 are to be performed, that is, for the signal hole mentioned above, the electroplating in A210 is to thicken the preset conductive layer in the signal hole, and for the another through hole, the electroplating in A210 is to form the conductive structure directly in the through hole.

At A211, perform subsequent processes of outer pattern transferring, outer surface processing, profile milling, shipment detecting and the like to obtain the multi-layer circuit board.

The present disclosure has disclosed example implementations, and although specific terms are employed, they are used and should be interpreted merely in a generic and descriptive sense, not for purposes of limitation. In some instances, as would be apparent to one skilled in the art, features, characteristics and/or elements described in connection with a particular implementation may be used alone or in combination with features, characteristics and/or elements described in connection with another implementation, unless expressly stated otherwise. It will, therefore, be understood by those skilled in the art that various changes in form and details may be made without departing from the scope of the present disclosure as set forth in the appended claims.

## Claims

1. A method for preparing a multi-layer circuit board, comprising:
forming a preset through hole at a position of each preset core board, corresponding to a local conductive through hole, of the multi-layer circuit board, and forming a preset conductive structure in the preset through hole, the local conductive through hole being a through hole having a conductive structure therein only at a position of the multi-layer circuit board corresponding to part of core boards, the preset core board being the core board corresponding to the conductive structure in at least one local conductive through hole, and an aperture of the preset through hole being greater than an aperture of the local conductive through hole;
stacking and pressing all the core boards of the multi-layer circuit board together, to obtain a compression structure;
forming the local conductive through hole in the compression structure, so that the preset conductive structure is formed into a preset conductive layer; and
electroplating the compression structure, so that the conductive structure is formed only at a position, corresponding to the preset conductive layer, in the local conductive through hole.

2. The method of claim 1, wherein the forming a preset through hole at a position of each preset core board, corresponding to a local conductive through hole, of the multi-layer circuit board comprises:
forming the preset through hole at the position of each preset core board, corresponding to the local conductive through hole, of the multi-layer circuit board by mechanical drilling or laser drilling.

3. The method of claim 1, wherein the forming a preset conductive structure in the preset through hole comprises:
performing chemical plating and electroplating on the preset core board sequentially, so as to form the preset conductive structure in the preset through hole.

4. The method of claim 1, wherein an adhesive layer is formed between any two adjacent core boards of the multi-layer circuit board;
for two preset conductive structures located at corresponding positions of any two adjacent preset core boards, at least one preset conductive structure has a protruding portion exceeding the preset through hole where the preset conductive structure is located and extending towards the other preset conductive structure, and in a stacking direction of the core boards in which the core boards are stacked, a length of the protruding portion is greater than or equal to a thickness of the adhesive layer.

5. The method of claim 1, wherein
for two preset conductive structures located at corresponding positions of any two adjacent preset core boards, each preset conductive structure has a protruding portion exceeding the preset through hole where the preset conductive structure is located and extending towards the other preset conductive structure, and in a stacking direction of the core boards in which the core boards are stacked, a total length of protruding portions of the two preset conductive structures is greater than or equal to a thickness of an adhesive layer between the two adjacent preset core boards.

6. The method of claim 1, wherein
the preset conductive structure is a solid conductive pillar.

7. The method of claim 1, wherein the forming the local conductive through hole in the compression structure, so that the preset conductive structure is formed into a preset conductive layer comprises:
forming the local conductive through hole in the compression structure, and removing a middle portion of the preset conductive structure during forming the local conductive through hole, so that a remaining portion of the preset conductive structure is formed into the preset conductive layer.

8. The method of claim 1, wherein the forming the local conductive through hole in the compression structure, so that the preset conductive structure is formed into a preset conductive layer comprises:
forming the local conductive through hole in the compression structure by mechanical drilling, and removing a middle portion of the preset conductive structure during the mechanical drilling, so that a remaining portion of the preset conductive structure is formed into the preset conductive layer.

9. The method of claim 1, wherein
the conductive structure in the local conductive through hole is a hollow conductive pillar.

10. The method of claim 1, wherein
the preset conductive structure and the conductive structure are made of copper.
